# EUROPEAN PATENT APPLICATION

(11) **EP 4 625 106 A1**
(43) Date of publication of application: **01.10.2025**
(21) Application number: 24905120.2
(22) Date of filing: 29.09.2024
(51) Int. Cl.: G06F 1/20

(54) **LIQUID COOLING HEAT DISSIPATION UNIT, LIQUID COOLING HEAT DISSIPATION DEVICE, AND SERVER**

(30) Priority: 28.12.2023 CN 202311829963
(71) Applicant: Suzhou Metabrain Intelligent Technology Co., Ltd., Suzhou, Jiangsu 215000 (CN)
(72) Inventor: LIN, Zijian, Suzhou, Jiangsu 215000 (CN); YU, Shimao, Suzhou, Jiangsu 215000 (CN); ZHANG, Hailong, Suzhou, Jiangsu 215000 (CN)
(74) Representative: Michalski Hüttermann & Partner Patentanwälte mbB
(86) International application number: PCT/CN2024/122497
(87) International publication number: WO 2025/139158

(57) **Abstract**

The present disclosure relates to the technical field of liquid-cooling heat dissipation devices, and discloses a liquid-cooling heat dissipation unit, a liquid-cooling heat dissipation device and a server wherein the liquid-cooling heat dissipation unit includes a liquid-cooling plate body and a supporting plate; The liquid cooling plate body is provided with a liquid-cooling cavity, a liquid inlet and a liquid outlet, both of which are communicated with the liquid-cooling cavity; The support plate is adapted to connect to the component to be cooled, and the liquid-cooling plate body is connected to connected to one side of the support plate facing the component to be cooled. The liquid-cooling heat dissipation unit disclosed by the present disclosure has high overall strength and is not easy to be damaged.

## Description

### CROSS-REFERENCE TO RELATED APPLICATION

The present disclosure claims the priority of Chinese patent application filed in CNIPA on December 28, 2023, with the application number of 202311829963.8 and the application name of "LIQUID-COOLING HEAT DISSIPATION UNIT, LIQUID-COOLING HEAT DISSIPATION DEVICE AND SERVER", the entire contents of which are incorporated into the present disclosure by reference.

### FIELD

The present disclosure relates to the technical field of liquid-cooling heat dissipation devices, in particular to a liquid-cooling heat dissipation unit, a liquid-cooling heat dissipation device and a server.

### BACKGROUND

When faced with scenarios requiring substantial computational power, servers are often equipped with multiple GPU (Graphics Processing Unit) chips. While these GPU chips meet the computational demands, they also tend to generate significant heat due to their high power consumption. Using air-cooling heat dissipation to dissipate heat from the GPU chips proves ineffective, and such systems impose strict requirements on height, fan quantity, and power, often leading to an increase in the server chassis height. In contrast, liquids have a much higher specific heat capacity than air, making liquid-cooling heat dissipation device more efficient than air-cooling heat dissipation. Additionally, liquid-cooling heat dissipation device are shorter in height and occupy less space within the server chassis.

An existing liquid-cooling heat dissipation device comprises multiple liquid-cooling plates, an inlet water system, and an outlet water system. Each liquid-cooling plate includes an aluminum alloy cover plate and an aluminum alloy base plate, which are assembled to form a cavity. Both ends of the liquid-cooling plate are equipped with water ports connected to the cavity, and these ports are linked to the inlet and outlet water systems via rubber hoses. Each aluminum alloy base plate of the liquid-cooling plates is mounted onto the corresponding GPU chip using spring screws. However, the overall structural strength of this liquid-cooling heat dissipation device is relatively low, making it prone to damage during disassembly and installation.

### SUMMARY

In view of this, the present disclosure provides a liquid-cooling heat dissipation unit, a liquid-cooling heat dissipation device and a server to solve the problem that the liquid-cooling heat dissipation device is low in strength and easy to be damaged.

On a first aspect, the present disclosure provides a liquid-cooling heat dissipation unit, including a liquid-cooling plate body and a support plate; the liquid-cooling plate body provided with a liquid-cooling cavity, a liquid inlet and a liquid outlet, wherein the liquid inlet and the liquid outlet are both communicated with the liquid-cooling cavity; the support plate, configured to be connected to a component to be cooled, and the liquid-cooling plate body is connected to the support plate on a side of the support plate facing the component to be cooled.

In some embodiments, the liquid-cooling plate body is protrudingly provided with a positioning part, the positioning part being internally provided with a positioning cavity that communicates with the liquid-cooling cavity, and both the liquid inlet and the liquid outlet communicate with the liquid-cooling cavity through the positioning cavity; wherein the support plate is correspondingly provided with a positioning hole, and the positioning part is connected to the positioning hole.

In some embodiments, the positioning hole is a through hole, and when the liquid-cooling plate body is connected to the support plate, a top of the positioning part facing away from the liquid-cooling plate body and a top of the support plate facing away from the component to be cooled are in a same plane.

In some embodiments, the liquid-cooling plate body is provided with a first connecting hole, and the support plate is provided with a second connecting hole, and the first connecting hole is correspondingly arranged with the second connecting hole and connected by a first fastener;

In some embodiments, the liquid-cooling plate body is made of a copper plate.

In some embodiments, the support plate is provided with a sink groove which is recessed toward a direction of the component to be cooled, and a bottom of the sink groove is provided with a third connecting hole which is connected to the component to be cooled through a second fastener.

On a second aspect, the present disclosure provides a liquid-cooling heat dissipation device, including:
the liquid-cooling dissipation unit according to above description, the liquid-cooling heat dissipation device includes at least two groups of liquid-cooling dissipation units arranged in sequence along a first direction, and each group of liquid-cooling dissipation units is provided with at least two liquid-cooling dissipation units arranged in sequence along a second direction perpendicular to the first direction;
a first bracket, extending along the second direction, arranged between two adjacent groups of liquid-cooling dissipation units, and connected to each liquid-cooling dissipation unit in two adjacent groups;
a liquid inlet system, wherein the liquid inlet of each liquid-cooling dissipation unit communicates with the liquid inlet system; and
a liquid outlet system, wherein the liquid outlet of each liquid-cooling dissipation unit communicates with the liquid outlet system.

In some embodiments, in the first direction, the liquid inlet system and the liquid outlet system are both arranged at the same side of at least two groups of liquid-cooling heat dissipation units.

In some embodiments, the liquid-cooling dissipation units are provided with two groups, one group is a first liquid-cooling heat dissipation unit far away from the liquid inlet system and the liquid outlet system and the other group is a second liquid-cooling heat dissipation unit close to the liquid inlet system and the liquid outlet system; wherein the liquid inlet of the first liquid-cooling dissipation unit communicates with the second liquid-cooling dissipation unit corresponding to the first direction through a first liquid inlet pipeline, and the liquid inlet of the second liquid-cooling dissipation unit communicates with the liquid inlet system through a second liquid inlet pipeline; wherein the liquid outlet of the first liquid-cooling dissipation unit communicates with the second liquid-cooling dissipation unit corresponding to the first direction through a first liquid outlet pipeline, and the liquid outlet of the second liquid-cooling dissipation unit communicates with the liquid outlet system through a second liquid outlet pipeline.

In some embodiments, the liquid-cooling heat dissipation device further including:
a second bracket, extending along the second direction and connected to one end of a group of the first liquid-cooling dissipation units far away from the liquid inlet system; and
a third bracket, extending along the second direction and connected to one end of a group of the second liquid-cooling dissipation units close to the liquid inlet system.

In some embodiments, both ends of the support plate of the first liquid-cooling heat dissipation unit in the first direction are respectively protrudingly provided with a first connecting block and a second connecting block, and the support plate of the second liquid-cooling heat dissipation unit in the first direction are respectively protrudingly provided with a third connecting block and a fourth connecting block, and the first connecting block, the second connecting block, the third connecting block and the fourth connecting block are all arranged at one end close to the component to be cooled; wherein one side of the first bracket in the first direction is connected to the first connecting block of a group of first liquid-cooling dissipation units, and the other side is connected to the third connecting block of a group of second liquid-cooling dissipation units, and the second bracket is connected to the second connecting block of a group of the first liquid-cooling dissipation units, and the third bracket is connected to the fourth connecting block of a group of the second liquid-cooling dissipation units.

In some embodiments, the first bracket is provided with a first protruding part protruding away from the component to be cooled, and the first liquid inlet pipeline and the first liquid outlet pipeline are both arranged at the first protruding part.

In some embodiments, the third bracket is provided with a second protruding part protruding away from the component to be cooled, and the second liquid inlet pipeline and the second liquid outlet pipeline are both arranged at the second protruding part.

In some embodiments, the liquid-cooling heat dissipation device further including a lifting handle, two ends of which are detachably connected to the second bracket and the third bracket respectively, and an installation groove is arranged in a middle of the lifting handle, wherein the installation groove is detachably connected to the first bracket, the lifting handle is divided into two handle parts through the installation groove, and an operation interval convenient for operation is formed between the handle parts and the support plate.

In some embodiments, the support plate of the first liquid-cooling heat dissipation unit is provided with a first avoidance groove and a second avoidance groove on the side facing the component to be cooled, and the first avoidance groove and the second avoidance groove are arranged at intervals in the second direction, and one end of the first liquid inlet pipeline is arranged in the first avoidance groove, and one end of the first liquid out pipeline is arranged in the second avoidance groove;
the side of the second liquid-cooling dissipation unit facing the component to be cooled is provided with a third avoidance groove and a fourth avoidance groove, and the third avoidance groove and the fourth avoidance groove are arranged at intervals in the second direction, and both ends of the second liquid-cooling dissipation unit in the first direction are provided with the third avoidance groove and the fourth avoidance groove;
an other end of the first liquid inlet pipeline is arranged in the third avoidance groove close to the first liquid-cooling dissipation unit, and an other end of the first liquid outlet pipeline is arranged in the fourth avoidance groove close to the first liquid-cooling dissipation unit;
one end of the second liquid inlet pipeline is arranged in the third avoidance groove close to the liquid inlet system, and one end of the second liquid outlet pipeline is arranged in the fourth avoidance groove close to the liquid outlet system.

In some embodiments, the liquid inlet system includes a liquid inlet separator and a liquid inlet joint, and the liquid inlet separator communicates with one end of the second liquid inlet pipeline far away from the second liquid-cooling heat dissipation unit and communicates with the liquid inlet joint through a third liquid inlet pipeline; the liquid outlet system includes a liquid outlet collector and a liquid outlet j oint, wherein the liquid outlet collector communicates with one end of the second liquid outlet pipeline far away from the second liquid-cooling heat dissipation unit and communicates with the liquid outlet joint through a third liquid outlet pipeline.

In some embodiments, in the first direction, the liquid inlet separator is arranged between the liquid outlet collector and the second liquid-cooling heat dissipation unit; the liquid inlet separator is provided with a fifth avoidance groove, and the second liquid outlet pipeline passes through the fifth avoidance groove and communicates with the liquid outlet collector.

In some embodiments, in the first direction, the liquid outlet liquid collector is arranged between the liquid inlet separator and the second liquid-cooling heat dissipation unit; the liquid outlet liquid collector is provided with a fifth avoidance groove, and the second liquid inlet pipeline passes through the fifth avoidance groove and communicates with the liquid inlet liquid collector .

In some embodiments, the liquid-cooling heat dissipation device further including a first fixing piece, a second fixing piece and a third fixing piece; wherein the first fixing piece is fixedly connected to one end of the liquid inlet separator and one corresponding end of the liquid outlet collector, and is adapted to connect to the component to be cooled; the second fixing piece is fixedly connected to the other end of the liquid inlet separator and is adapted to connect to the component to be cooled; the third fixing piece is fixedly connected to the liquid inlet separator and the liquid outlet collector, is located between the first fixing piece and the second fixing piece, and is adapted to connect to the component to be cooled at one side of the liquid outlet collector far away from the liquid inlet collector.

In some embodiments, the liquid-cooling heat dissipation device further includes a fixed block, which is adapted to connect to a chassis of a server, and the liquid inlet joint and the liquid outlet joint are both connected to the fixed block.

On a third aspect, the present disclosure further provides a server, including a component to be cooled and the liquid-cooling heat dissipation device according to above description, wherein the component to be cooled is a graphics processor.

### BRIEF DESCRIPTION OF THE DRAWINGS

In order to explain the specific embodiments of the present disclosure or the technical solution in the prior art more clearly, the drawings needed in the description of the specific embodiments or the prior art will be briefly introduced below. Apparently, the drawings in the following description are some embodiments of the present disclosure, and other drawings can be obtained according to these drawings without creative work for persons skilled in the art.
FIG. 1 is a schematic diagram of a liquid-cooling heat dissipation unit according to an embodiment of the present disclosure;
FIG. 2 is an explosion diagram of a liquid-cooling heat dissipation unit according to an embodiment of the present disclosure;
FIG. 3 is a partial cross-sectional view of a liquid-cooling plate body of a liquid-cooling dissipation unit according to an embodiment of the present disclosure;
FIG. 4 is a structural schematic diagram of a liquid-cooling heat dissipation device according to an embodiment of the present disclosure;
FIG. 5 is a partial structural diagram of a liquid-cooling heat dissipation device according to an embodiment of the present disclosure;
FIG. 6 is a schematic diagram of liquid flow of the liquid-cooling heat dissipation device according to the embodiment of the present disclosure;
FIG. 7 is a schematic diagram of a liquid inlet system and a liquid outlet system of a liquid-cooling heat dissipation device according to an embodiment of the present disclosure;
FIG. 8 is a schematic diagram of a fixing block of a liquid-cooling heat dissipation device according to an embodiment of the present disclosure.

### DETAILED DESCRIPTION

In order to make the purpose, technical solution and advantages of the embodiments of the disclosure clearer, the technical solution in the embodiments of the present disclosure will be described clearly and completely with the attached drawings. Apparently, the described embodiments are a part of the embodiments of the disclosure, but not the whole embodiments. Based on the embodiments in the present disclosure, all other embodiments obtained by those skilled in the art without creative work belong to the protection scope of the present disclosure.

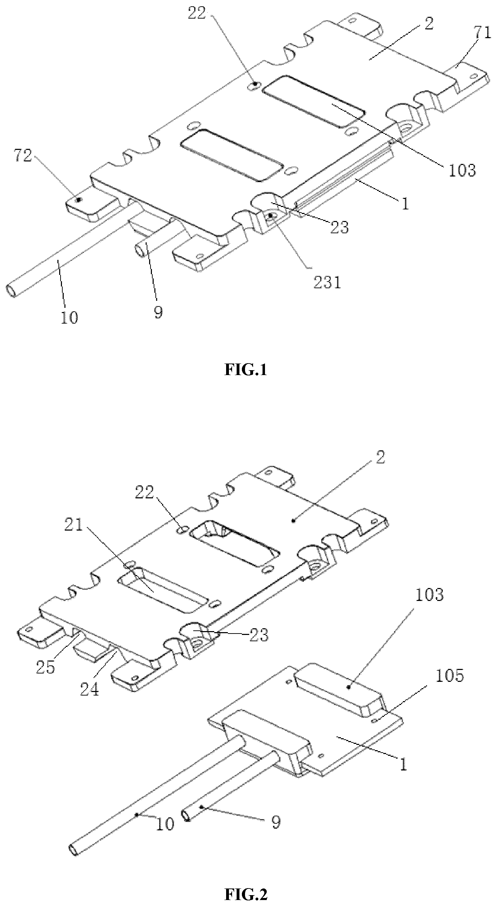

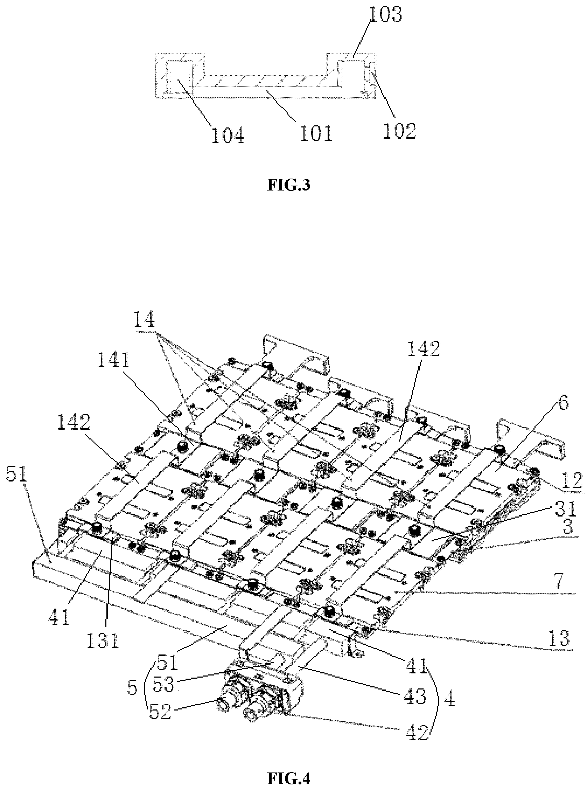

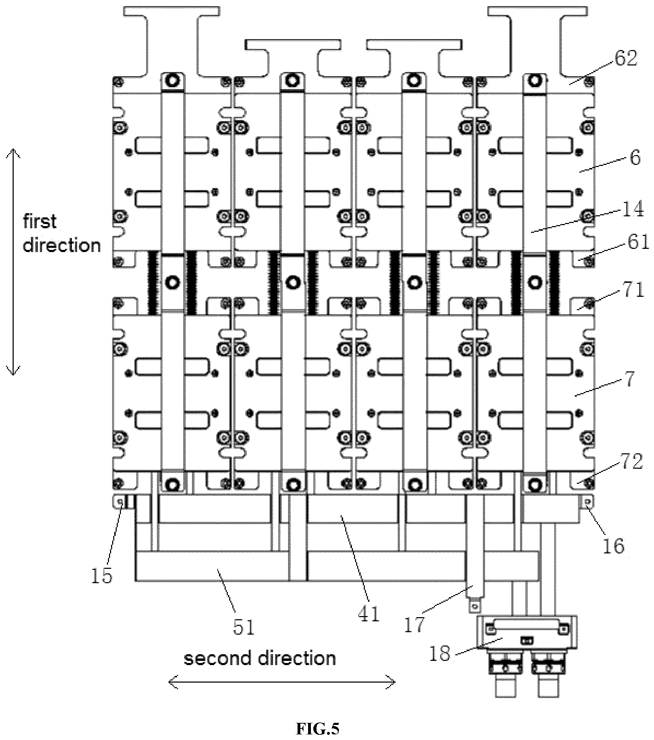

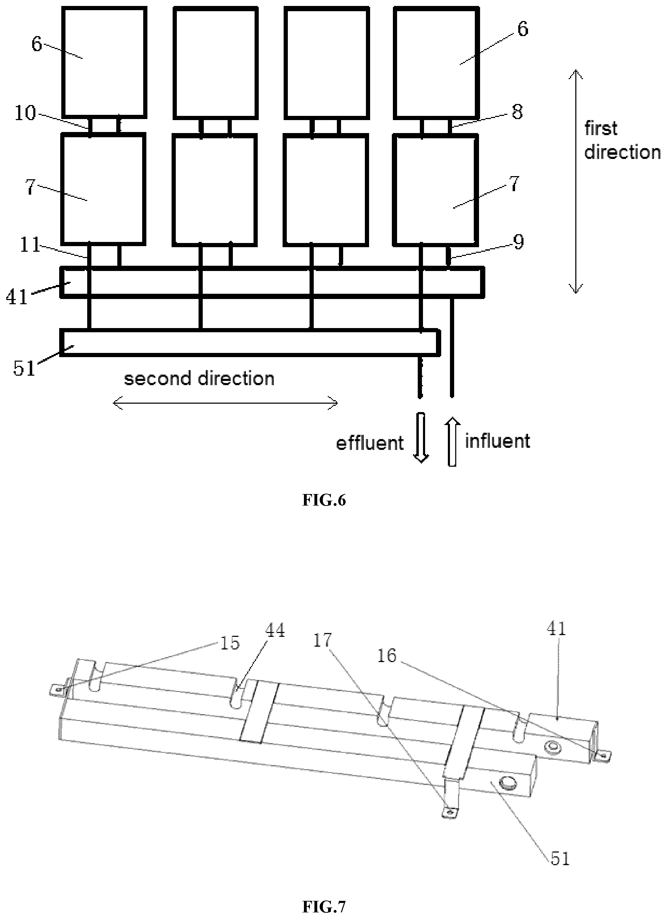

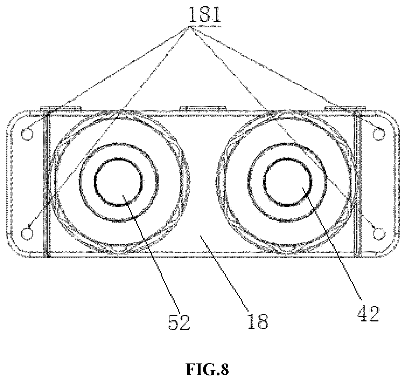

Embodiments of the present disclosure will be described below with reference to FIGs. 1 to 8.

According to an embodiment of the present disclosure, on the one hand, as shown in FIGs. 1 to 3, a liquid-cooling heat dissipation unit is provided, including a liquid-cooling plate body 1 and a support plate 2; The liquid-cooling plate body 1 is provided with a liquid-cooling cavity 101, a liquid inlet 102 and a liquid outlet, both of which communicate with the liquid-cooling cavity 101; The support plate 2 is adapted to connect to a component to be cooled, and the liquid-cooling plate body 1 is connected to a side of the support plate 2 facing the component to be cooled.

The liquid-cooling plate body 1 of each liquid-cooling dissipation unit is connected to the support plate 2, and the support plate 2 can not only stably connect the liquid-cooling plate body 1 to the component to be cooled, but also make the liquid-cooling plate body 1 directly contact the component to be cooled, and also improve the overall strength of the liquid-cooling dissipation unit, so that the liquid-cooling dissipation unit is not easy to be damaged during installation and disassembly. And due to the support plate 2 and the liquid-cooling plate body 1 are both plate-shaped, the overall height of the liquid-cooling heat dissipation unit is low, which saves the space in the height direction and can meet the liquid-cooling heat dissipation scheme of the graphic display of the 1U height server with small space.

Specifically, in some embodiments, the component to be cooled may be a GPU (graphics processor), the liquid-cooling dissipation unit may be a water-cooling dissipation unit, and the cooling liquid is water.

In some embodiments, the liquid-cooling plate body 1 is protrudingly provided with a positioning part 103, and the positioning part 103 is internally provided with a positioning cavity 104 that communicates with the liquid-cooling cavity 101, and both the liquid inlet 102 and the liquid outlet communicate with the liquid-cooling cavity 101 through the positioning cavity 104; The support plate 2 is correspondingly provided with a positioning hole 21, and the positioning part 103 is connected in the positioning hole 21.

The positioning part 103 can not only play a positioning role in the installation process of the liquid-cooling plate body 1 and the support plate 2, and simplify the installation of the liquid-cooling plate body 1 and the support plate 2, but also provide a larger space for the liquid inlet 102 and the liquid outlet, to provide a relatively larger liquid inlet 102 and the liquid outlet without increasing the thickness of the liquid-cooling plate body 1. Moreover, the thickness of the positioning cavity 104 is greater than that of the liquid-cooling cavity 101, and the liquid inlet 102 and the liquid outlet communicate with the positioning cavity 104, and the positioning cavity 104 can be cushioned during liquid inlet and liquid outlet, to facilitate the entry and discharge of the cooling liquid and enhance the fluidity of the cooling liquid.

Specifically, in some embodiments, the positioning cavity 104 is also provided with a partition plate, and one end of the partition plate is connected between the liquid inlet 102 and the liquid outlet, so that the part of the positioning cavity 104 close to the liquid inlet 102 and the liquid outlet is divided into a first cavity and a second cavity, and both the first cavity and the second cavity communicate with the liquid-cooling cavity 101; Alternatively, the first cavity and the second cavity may or may not be communicated; The first cavity communicates with the liquid inlet 102, and the second cavity communicates with the liquid outlet. The arrangement of the partition plate can prevent the liquid inlet 102 from being directly discharged from the liquid outlet, further enhancing the fluidity of the cooling liquid, and at the same time preventing the temperature of the cooling liquid inside the liquid-cooling plate body 1 from being greatly different, thereby avoiding uneven heat dissipation.

In some embodiments, the positioning hole 21 is a through hole. After the liquid-cooling plate body 1 and the support plate 2 are connected in place, the top of the positioning part 103 facing away from the liquid-cooling plate body 1 and the top of the support plate 2 facing away from the component to be cooled are in the same plane.

The top of the positioning part 103 facing away from the liquid-cooling plate body 1 and the top of the support plate 2 facing away from the component to be cooled are in the same plane, to ensure the flatness of the top of the liquid-cooling dissipation unit facing away from the component to be cooled, and prevent the protrusion from being abrased, scratched or interfered with other limiting components.

Alternatively, the positioning hole 21 may be a blind hole, with the hole opening facing the component to be cooled.

In some embodiments, the liquid-cooling plate body 1 is provided with a first connecting hole 105, and the support plate 2 is provided with a second connecting hole 22. The first connecting hole 105 is arranged corresponding to the second connecting hole 22 and connected by a first fastener.

The first fastener can fixedly connect the liquid-cooling plate body 1 and the support plate 2 through the first connecting hole 105 and the second connecting hole 22. Specifically, the first fastener can be a screw, bolt and other fastening structures that are convenient to disassemble, or a rivet and other fastening structures that are not convenient to disassemble.

In some embodiments, the liquid-cooling plate body 1 is made of a copper plate.

Copper has a large specific heat capacity and a better heat dissipation effect, and the height of the whole liquid-cooling heat dissipation unit can be set between 8mm and 10mm, preferably 9mm, by combining the positioning part 103 and the positioning hole 21, which saves a lot of space for the inside of the server with components to be cooled.

In some embodiments, the support plate 2 is provided with a sink groove 23 that is recessed toward the direction of the component to be cooled, and the bottom of the sink groove 23 is provided with a third connecting hole 231, which is connected to the component to be cooled by a second fastener.

The arrangement of the sink groove 23 can sink the second fastener into the support plate 2, and prevent the second fastener from protruding from the top of the support plate 2, and prevent the protruding second fastener from increasing the overall height of the liquid-cooling dissipation unit.

Specifically, the second fastener can be a screw, bolt and other fastening structures that are convenient to disassemble, or a rivet and other fastening structures that are not convenient to disassemble. Preferably, the third connecting hole 231 is detachably connected to the component to be cooled by the second fastener.

In some embodiments, the periphery of the support plate 2 is provided with a peripheral wall extending toward the component to be cooled, and the peripheral wall is provided with a limiting groove, and the liquid-cooling plate body 1 is arranged in the limiting groove.

The arrangement of the peripheral wall can form the support plate 2 into a cover shape, and can cooperate with the component to be cooled to form an installation cavity, to better protect and support the liquid-cooling plate body 1. And the setting of the limiting groove can limit and fix the liquid-cooling plate body 1.

According to the embodiments of the present disclosure, on the other hand, as shown in FIG. 1 to 8, there is also provided a liquid-cooling heat dissipation device, which includes the above-mentioned liquid-cooling heat dissipation unit, the first bracket 3, the liquid inlet system 4 and the liquid outlet system 5, wherein the liquid-cooling heat dissipation unit includes at least two groups sequentially arranged along the first direction, and each group is provided with at least two liquid-cooling heat dissipation units sequentially arranged along the second direction; Each liquid-cooling dissipation unit includes a liquid-cooling plate body 1 and a support plate 2; The liquid-cooling plate body 1 is provided with a liquid-cooling cavity 101, a liquid inlet 102 and a liquid outlet, both of which communicate with the liquid-cooling cavity 101; The support plate 2 is adapted to connect to the component to be cooled, and the liquid-cooling plate body 1 is connected to one side of the support plate 2 facing the component to be cooled. The first bracket 3 extends along the second direction, is arranged between two adjacent groups of liquid-cooling heat dissipation units, and is connected to each liquid-cooling heat dissipation unit in two adjacent groups; The liquid inlet 102 of each liquid-cooling dissipation unit communicates with the liquid inlet system 4; The liquid outlet of each liquid-cooling dissipation unit communicates with the liquid outlet system 5; Wherein the first direction is perpendicular to the second direction.

The liquid inlet system 4 can fill the cooling liquid into each liquid-cooling heat dissipation unit through the liquid inlet 102, and lead out the cooling liquid absorbed by each liquid-cooling heat dissipation unit through the liquid outlet, to realize the heat dissipation effect of the liquid-cooling heat dissipation unit. The arrangement of the first bracket 3 can connect two groups of liquid-cooling dissipation units adjacent in the first direction into a whole, which greatly enhances the overall strength of the liquid-cooling heat dissipation device and makes the liquid-cooling dissipation units not easy to be damaged during installation and disassembly.

In some embodiments, in the first direction, both the liquid inlet system 4 and the liquid outlet system 5 are arranged at one side of at least two groups of liquid-cooling heat dissipation units.

In the related art, the liquid inlet system 4 and the liquid outlet system 5 are respectively arranged at the two sides of at least two groups of liquid-cooling heat dissipation units, and the liquid outlet collector 51 of the liquid outlet system 5 needs a long hose to be connected to the liquid outlet joint 52, so there is a great risk of rubbing devices in the server. In this embodiment, the liquid inlet system 4 and the liquid outlet system 5 are both arranged at one side of at least two groups of liquid-cooling heat dissipation units, and the liquid outlet collector 51 and the liquid outlet joint 52 of the liquid outlet system 5 need not be connected by long pipes, only pipes with appropriate lengths are needed for connection, thus reducing the space occupied by the liquid-cooling heat dissipation device as a whole and avoiding the risk of rubbing devices. The liquid inlet separator 41 of the liquid inlet system 4 is arranged close to the liquid inlet connector 42.

In some embodiments, there are two groups of liquid-cooling heat dissipation units, one group far away from the liquid inlet system 4 and the liquid outlet system 5 is the first liquid-cooling heat dissipation unit 6, and the other group close to the liquid inlet system 4 and the liquid outlet system 5 is the second liquid-cooling heat dissipation unit 7; The liquid inlet 102 of the first liquid-cooling dissipation unit 6 communicates with the second liquid-cooling dissipation unit 7 corresponding to the first direction through the first liquid inlet pipeline 8, and the liquid inlet 102 of the second liquid-cooling dissipation unit 7 communicates with the liquid inlet system 4 through the second liquid inlet pipeline 9; The liquid outlet of the first liquid-cooling dissipation unit 6 communicates with the second liquid-cooling dissipation unit 7 corresponding to the first direction through a first liquid outlet pipeline 10, and the liquid outlet of the second liquid-cooling dissipation unit 7 communicates with the liquid outlet system 5 through a second liquid outlet pipeline 11.

The second liquid inlet pipeline 9 and the first liquid inlet pipeline 8 communicate the liquid inlet of the second liquid-cooling dissipation unit 7 and the first liquid-cooling dissipation unit 6 in turn, and the first liquid outlet pipeline 10 and the second liquid outlet pipeline 11 communicate the liquid outlet of the first liquid-cooling dissipation unit 6 and the second liquid-cooling dissipation unit 7 in turn, which can save the pipeline length and simplify the pipeline structure.

Specifically, the liquid-cooling plate body 1 of the second liquid-cooling dissipation unit 7 is provided with a liquid inlet 102 and a liquid outlet at both ends in the first direction, and the liquid inlet 102 at one end corresponds to the liquid outlet at the other end in position. One end of the liquid-cooling plate body 1 of the first liquid-cooling heat dissipation unit 6 facing the second liquid-cooling heat dissipation unit 7 is provided with a liquid inlet 102 and a liquid outlet, and the position of the liquid inlet 102 of the first liquid-cooling heat dissipation unit 6 corresponds to the position of the liquid outlet of the second liquid-cooling heat dissipation unit 7 facing the first liquid-cooling heat dissipation unit 6.

A group of third liquid-cooling dissipation units may be further included between the first liquid-cooling dissipation unit 6 and the second liquid-cooling dissipation unit 7, and both ends of the third liquid-cooling dissipation unit in the first direction are provided with a liquid inlet 102 and a liquid outlet, which are connected in series between the first liquid-cooling dissipation unit 6 and the second liquid-cooling dissipation unit 7 through pipelines. The third liquid-cooling dissipation unit may have one group or a plurality of groups at intervals along the first direction.

In some embodiments, the device further includes a second bracket 12 and a third bracket 13; The second bracket 12 extends in the second direction and is connected to one end of a group of first liquid-cooling dissipation units 6 far away from the liquid inlet system 4. The third bracket 13 extends in the second direction, and is connected to one end of a group of second liquid-cooling dissipation units 7 close to the liquid inlet system 4.

The second bracket 12 can connect a group of first liquid-cooling heat dissipation units 6 into a whole, further enhancing the connection strength and overall strength of a group of first liquid-cooling heat dissipation units 6; The third bracket 13 can connect a group of second liquid-cooling heat dissipation units 7 into a whole, further enhancing the connection strength and overall strength of a group of second liquid-cooling heat dissipation units 7.

Specifically, the third bracket 13 is fixedly connected to the liquid inlet system 4 or the liquid outlet system 5.

In some embodiments, both ends of the support plate 2 of the first liquid-cooling heat dissipation unit 6 in the first direction are respectively protrudingly provided with a first connecting block 61 and a second connecting block 62, and the support plate 2 of the second liquid-cooling heat dissipation unit 7 in the first direction are respectively protrudingly provided with a third connecting block 71)and a fourth connecting block 72, and the first connecting block 61, the second connecting block 62, the third connecting block 71 and the fourth connecting block 72 are all arranged at one end close to the component to be cooled; wherein one side of the first bracket 3 in the first direction is connected to the first connecting block 61 of a group of first liquid-cooling dissipation units 6, and the other side is connected to the third connecting block 71 of a group of second liquid-cooling dissipation units 7, and the second bracket 12 is connected to the second connecting block 62 of a group of the first liquid-cooling dissipation units 6, and the third bracket 13 is connected to the fourth connecting block 72 of a group of the second liquid-cooling dissipation units 7.

The first connecting block 61, the second connecting block 62, the third connecting block 71 and the fourth connecting block 72 are all arranged at one end close to the component to be cooled, so that the connecting height of the first bracket 3, the second bracket 12 and the third bracket 13 can be reduced, and the connected first bracket 3, the second bracket 12 and the third bracket 13 can be prevented from protruding from the top of the liquid-cooling heat dissipation device.

Specifically, in some embodiments, there are two first connecting blocks 61, which are arranged on both sides of the support plate 2 of the first liquid-cooling heat dissipation unit 6 in the second direction; There are two second connecting blocks 62, which are arranged on both sides of the support plate 2 of the first liquid-cooling heat dissipation unit 6 along the second direction. There are two third connecting blocks 71, which are arranged on both sides of the support plate 2 of the second liquid-cooling heat dissipation unit 7 along the second direction. There are two fourth connecting blocks 72, which are arranged on both sides of the support plate 2 of the second liquid-cooling heat dissipation unit 7 in the second direction. The first connecting block 61 is provided with a fourth connecting hole, and the first bracket 3 is correspondingly provided with a fifth connecting hole, and the fourth connecting hole and the fifth connecting hole are connected by a third fastener. The third fastener can be a screw, bolt and other fastening structures that are convenient to disassemble, or a rivet and other fastening structures that are not convenient to disassemble. The second connecting block 62 is provided with a sixth connecting hole, and the second bracket 12 is correspondingly provided with a seventh connecting hole, and the sixth connecting hole and the seventh connecting hole are connected by a fourth fastener. The fourth fastener can be a screw, bolt and other fastening structures that are convenient to disassemble, or a rivet and other fastening structures that are not convenient to disassemble. The third connecting block 71 is provided with an eighth connecting hole, and the first bracket 3 is correspondingly provided with a ninth connecting hole, and the eighth connecting hole and the ninth connecting hole are connected by a fifth fastener. The fifth fastener can be a screw, bolt and other fastening structures that are convenient to disassemble, or a rivet and other fastening structures that are not convenient to disassemble. The fourth connecting block 72 is provided with a tenth connecting hole, and the third bracket 13 is correspondingly provided with an eleventh connecting hole. The tenth connecting hole and the eleventh connecting hole are connected by a sixth fastener, and the sixth fastener can be a screw, a bolt and other fastening structures that are convenient to disassemble, or a rivet and other fastening structures that are not convenient to disassemble.

In some embodiments, the first bracket 3 is provided with a first protrusion 31 protruding away from the component to be cooled, and the first liquid inlet pipe 8 and the first liquid outlet pipe 10 are both arranged at the first protrusion 31.

The first protrusion can avoid, limit and protect the first liquid inlet pipeline 8 and the first liquid outlet pipeline 10.

In some embodiments, the third bracket 13 is provided with a second protrusion 131 protruding away from the component to be cooled, and the second liquid inlet pipe 9 and the second liquid outlet pipe 11 are both arranged at the second protrusion 131.

The second protrusion can avoid, limit and protect the second liquid inlet pipeline 9 and the second liquid outlet pipeline 11.

Specifically, the first bracket 3, the second bracket 12 and the third bracket 13 can all be formed by sheet metal processing.

In some embodiments, a lifting handle 14 is also included, both ends of which are detachably connected to the second bracket 12 and the third bracket 13 respectively. The middle position of the lifting handle 14 is provided with an installation groove 141, which is detachably connected to the first bracket 3. The lifting handle 14 is divided into two handle parts 142 through the installation groove 141, and an operation interval convenient for operation is formed between the handle parts 142 and the support plate 2.

The arrangement of the lifting handle 14 is convenient for maintenance personnel to operate. Two ends of the lifting handle 14 are respectively connected to the second bracket 12 and the third bracket 13, and an installation groove 141 is arranged in the middle position, and the lifting handle 14 is detachably connected to the first bracket 3 through the installation groove 141, so that the liquid-cooling heat dissipation unit can be avoided and damaged. An operation space is formed between the handle part 142 and the support plate 2, which is convenient for the fingers of maintenance personnel or lifting tools to pass through.

Specifically, in some embodiments, the lifting handle 14 can be formed from sheet metal parts with simple structure and less space occupation.

In some embodiments, the support plate 2 of the first liquid-cooling heat dissipation unit 6 is provided with a first avoidance groove and a second avoidance groove on the side facing the component to be cooled, and the first avoidance groove and the second avoidance groove are arranged at intervals in the second direction, and one end of the first liquid inlet pipeline 8 is arranged in the first avoidance groove, and one end of the first liquid out pipeline 10 is arranged in the second avoidance groove; the side of the second liquid-cooling dissipation unit 7 facing the component to be cooled is provided with a third avoidance groove 24 and a fourth avoidance groove 25, and the third avoidance groove 24 and the fourth avoidance groove 25 are arranged at intervals in the second direction, and both ends of the second liquid-cooling dissipation unit 7 in the first direction are provided with the third avoidance groove 24 and the fourth avoidance groove 25; an other end of the first liquid inlet pipeline 8)is arranged in the third avoidance groove 24 close to the first liquid-cooling dissipation unit 6, and an other end of the first liquid outlet pipeline 10 is arranged in the fourth avoidance groove 25 close to the first liquid-cooling dissipation unit 6; one end of the second liquid inlet pipeline 9 is arranged in the third avoidance groove 24 close to the liquid inlet system 4, and one end of the second liquid outlet pipeline 11 is arranged in the fourth avoidance groove 25 close to the liquid outlet system 5.

The arrangement of the first avoidance groove and the second avoidance groove can respectively avoid the first liquid inlet pipeline 8 and the first liquid outlet pipeline 10, thereby reducing the overall height of the first liquid-cooling heat dissipation unit 6. The arrangement of the third avoidance groove 24 and the fourth avoidance groove 25 can avoid the first liquid inlet pipeline 8 and the first liquid outlet pipeline 10 respectively, thus reducing the overall height of the second liquid-cooling heat dissipation unit 7; In addition, the second liquid inlet pipeline 9 and the second liquid outlet pipeline 11 can be avoided respectively, to reduce the overall height of the second liquid-cooling heat dissipation unit 7.

Specifically, in some embodiments, one end of the support plate 2 of the first liquid-cooling heat dissipation unit 6 is provided with a first bump, and the first bump is arranged between the first avoidance groove and the second avoidance groove, which can support the lifting handle 14 and increase the strength. Both ends of the support plate 2 of the second liquid-cooling heat dissipation unit 7 are provided with the second bumps, which are arranged between the third avoidance groove 24 and the fourth avoidance groove 25 to support the lifting handle 14 and increase the strength.

In some embodiments, the liquid inlet system 4 includes a liquid inlet separator 41 and a liquid inlet joint 42, and the liquid inlet separator 41 communicates with one end of the second liquid inlet pipeline 9 far away from the second liquid-cooling heat dissipation unit 7 and communicates with the liquid inlet joint 42 through a third liquid inlet pipeline; the liquid outlet system 5 includes a liquid outlet collector 51 and a liquid outlet joint 52, wherein the liquid outlet collector 51 communicates with one end of the second liquid outlet pipeline 11 far away from the second liquid-cooling heat dissipation unit 7 and communicates with the liquid outlet joint 52 through a third liquid outlet pipeline 53; In the first direction, the liquid inlet separator 41 is arranged between the liquid outlet collector 51 and the second liquid-cooling heat dissipation unit 7; The liquid inlet separator 41 is provided with a fifth avoidance groove 44, and the second liquid outlet pipeline 11 passes through the fifth avoidance groove 44 to communicate with the liquid outlet collector 51.

The arrangement of the fifth avoidance groove 44 can facilitate the communication between the second liquid outlet pipeline 11 and the liquid outlet collector 51, to facilitate the connection with the regular second liquid outlet pipeline 11, and can also limit and fix the liquid inlet separator 41 and the liquid outlet collector 51 to a certain extent.

Alternatively, in the first direction, the outlet liquid collector 51 is arranged between the inlet liquid separator 41 and the second liquid-cooling heat dissipation unit 7, and the outlet liquid collector 51 is provided with a fifth avoidance groove 44, and the second inlet pipeline 9 passes through the fifth avoidance groove (44) and communicates with the inlet liquid separator 41.

Specifically, in some embodiments, the second liquid inlet pipeline 9 is welded and fixed with the liquid inlet separator 41, and the second liquid outlet pipeline 11 is welded and fixed with the liquid outlet collector 51.

Specifically, in some embodiments, the liquid inlet separator 41 is a tubular structure, preferably a rectangular tube extending in the second direction, and is provided with a first inlet and a plurality of first outlets, wherein the first inlet communicates with the liquid inlet connector 42 through the third liquid inlet pipeline 43, and the number of the first outlets is the same as that of the second liquid-cooling heat dissipation units 7, and each first outlet communicates with the liquid inlet 102 of a second liquid-cooling heat dissipation unit 7 through the second liquid inlet pipeline 9; Or the number of the first outlets is greater than that of the second liquid-cooling dissipation units 7, the liquid inlet 102 of each second liquid-cooling dissipation unit 7 communicates with the corresponding first outlet through the second liquid inlet pipeline 9, and the remaining first outlets are sealed by the sealing cover. The liquid outlet collector 51 is a rectangular tubular structure, preferably a rectangular tube extending in the second direction, and is provided with a second outlet and a plurality of second inlets, wherein the second outlet communicates with the liquid outlet joint 52 through a third liquid outlet pipeline 53, and the number of the second inlets is the same as that of the second liquid-cooling heat dissipation units 7, and each second inlet communicates with the liquid outlet of a second liquid-cooling heat dissipation unit 7 through a second liquid outlet pipeline 11; Or the number of the second inlets is greater than that of the second liquid-cooling dissipation units 7, the liquid outlet of each second liquid-cooling dissipation unit 7 communicates with the corresponding second inlets through a second liquid outlet pipeline 11, and the remaining second inlets are sealed by a sealing cover.

In some embodiments, the device further includes a first fixing piece 15, a second fixing piece 16 and a third fixing piece 17; wherein the first fixing piece 15 is fixedly connected to one end of the liquid inlet separator 41 and one corresponding end of the liquid outlet collector 51, and is adapted to connect to the component to be cooled; the second fixing piece 16 is fixedly connected to the other end of the liquid inlet separator 41 and is adapted to connect to the component to be cooled; the third fixing piece 17 is fixedly connected to the liquid inlet separator 41 and the liquid outlet collector 51, is located between the first fixing piece 15 and the second fixing piece 16, and is adapted to connect to the component to be cooled at one side of the liquid outlet collector 51 far away from the liquid inlet collector 41.

The first fixing piece 15, the second fixing piece 16 and the third fixing piece 17 are distributed in a triangle shape, which can not only firmly connect the liquid outlet collector 51 and the liquid inlet separator 41 to the board of the component to be cooled, but also stably connect the liquid outlet collector 51 and the liquid inlet separator 41.

Specifically, in some embodiments, the first fixing piece 15 includes a first fixing plate and a second fixing plate. Both ends of the first fixing plate are welded with one end of the liquid inlet separator 41 and one end of the liquid outlet collector 51 respectively. One end of the second fixing plate is welded with the first fixing plate, and the other end is bent to abut against the board of the component to be cooled. The second fixing plate is provided with a twelfth connecting hole, which is connected to the board of the component to be cooled through a seventh fastener. One end of the second fixing piece 16 is welded with the other end of the liquid inlet separator 41, and the other end is bent to abut against the board of the component to be cooled. The second fixing piece 16 is provided with a thirteenth connecting hole, and the thirteenth connecting hole is connected to the board of the component to be cooled through the eighth fastener. The third fixing piece 17 includes a third fixing plate and a fourth fixing plate, wherein the third fixing plate is welded with the top ends of the liquid inlet separator 41 and the liquid outlet collector 51; one end of the fourth fixing plate is welded with the third fixing plate, and the other end is bent and abutted with the board of the component to be cooled; the fourth fixing plate is provided with a fourteenth connecting hole, and the fourteenth connecting hole is connected to the board of the component to be cooled through the ninth fastener. The device also includes a fourth fixing piece, which has a sheet structure and is welded with the top ends of the liquid inlet separator 41 and the liquid outlet collector 51.

In some embodiments, the liquid-cooling heat dissipation device further includes a fixed block 18, which is adapted to connect to the chassis of the server, and both the liquid inlet connector 42 and the liquid outlet connector 52 are connected to the fixed block 18.

The fixing block 18 is snap-connected to the front panel of the server chassis to fix the liquid inlet connector 42 and the liquid outlet connector 52. Preferably, both the liquid inlet connector 42 and the liquid outlet connector 52 can be quick plug connectors.

According to the embodiments of the present disclosure, on the other hand, a server is further provided, which includes a component to be cooled and the liquid-cooling heat dissipation device as above-mentioned, wherein the component to be cooled is a graphics processor.

Specifically, eight graphic processors, four first liquid-cooling dissipation units 6 and four second liquid-cooling dissipation units 7 are provided.

Although the embodiments of the present disclosure have been described in connection with the drawings, those skilled in the art can make various modifications and variations without departing from the spirit and scope of the present disclosure, and such modifications and variations are all within the scope defined by the appended claims.

### List of reference numerals:

1, liquid-cooling plate body;
101, liquid-cooling cavity;
102, liquid inlet;
103, positioning part;
104, positioning cavity;
105, first connecting hole;
2, support plate;
21, positioning hole;
22, second connecting hole;
23, sink groove;
231, third connecting hole;
24, third avoidance groove;
25, fourth avoidance groove;
3, first bracket;
31, first protruding part;
4, liquid inlet system;
41, liquid inlet separator;
42, liquid inlet joint;
43, third liquid inlet pipeline;
44, fifth avoidance groove;
5, liquid outlet system;
51, liquid outlet collector;
52, liquid outlet joint;
53, third liquid outlet pipeline;
6, first liquid-cooling dissipation unit;
61, first connecting block;
62, second connecting block;
7, second liquid-cooling dissipation unit;
71, third connecting block;
72, fourth connecting block;
8, first liquid inlet pipeline;
9, second liquid inlet pipeline;
10, first liquid outlet pipeline;
11, second liquid outlet pipeline;
12, second bracket;
13, third bracket;
131, second protruding part;
14, lifting handle;
141, installation groove;
142, handle part;
15, first fixing piece;
16, second fixing piece;
17, third fixing piece;
18, fixed block;
181, fixed hole.

## Claims

1. A liquid-cooling heat dissipation unit, comprising:
a liquid-cooling plate body (1), provided with a liquid-cooling cavity (101), a liquid inlet (102) and a liquid outlet, wherein the liquid inlet (102) and the liquid outlet are both communicated with the liquid-cooling cavity (101);
a support plate (2), configured to be connected to a component to be cooled, and the liquid-cooling plate body (1) is connected to the support plate (2) on a side of the support plate (2) facing the component to be cooled.

2. The liquid-cooling dissipation unit according to claim 1, wherein the liquid-cooling plate body (1) is protrudingly provided with a positioning part (103), the positioning part (103) being internally provided with a positioning cavity (104) that communicates with the liquid-cooling cavity (101), and both the liquid inlet (102) and the liquid outlet communicate with the liquid-cooling cavity (101) through the positioning cavity (104);
wherein the support plate (2) is correspondingly provided with a positioning hole (21), and the positioning part (103) is connected to the positioning hole (21).

3. The liquid-cooling dissipation unit according to claim 2, wherein the positioning hole (21) is a through hole, and when the liquid-cooling plate body (1) is connected to the support plate (2), a top of the positioning part (103) facing away from the liquid-cooling plate body (1) and a top of the support plate (2) facing away from the component to be cooled are in a same plane.

4. The liquid-cooling dissipation unit according to claim 1, wherein the liquid-cooling plate body (1) is provided with a first connecting hole (105), and the support plate (2) is provided with a second connecting hole (22), and the first connecting hole (105) is correspondingly arranged with the second connecting hole (22) and connected by a first fastener;
and/or the liquid-cooling plate body (1) is made of a copper plate.

5. The liquid-cooling heat dissipation unit according to any one of claims 1 to 4, wherein the support plate (2) is provided with a sink groove (23) which is recessed toward a direction of the component to be cooled, and a bottom of the sink groove (23) is provided with a third connecting hole (231) which is connected to the component to be cooled through a second fastener.

6. A liquid-cooling heat dissipation device, comprising:
the liquid-cooling dissipation unit according to any one of claims 1 to 6, the liquid-cooling heat dissipation device comprises at least two groups of liquid-cooling dissipation units arranged in sequence along a first direction, and each group of liquid-cooling dissipation units is provided with at least two liquid-cooling dissipation units arranged in sequence along a second direction perpendicular to the first direction;
a first bracket (3), extending along the second direction, arranged between two adjacent groups of liquid-cooling dissipation units, and connected to each liquid-cooling dissipation unit in two adjacent groups;
a liquid inlet system (4), wherein the liquid inlet (102) of each liquid-cooling dissipation unit communicates with the liquid inlet system (4); and
a liquid outlet system (5), wherein the liquid outlet of each liquid-cooling dissipation unit communicates with the liquid outlet system (5).

7. The liquid-cooling heat dissipation device according to claim 6, wherein in the first direction, the liquid inlet system (4) and the liquid outlet system (5) are both arranged at the same side of at least two groups of liquid-cooling heat dissipation units.

8. The liquid-cooling heat dissipation device according to claim 7, comprising a first liquid-cooling heat dissipation unit (6) far away from the liquid inlet system (4) and the liquid outlet system (5) and a second liquid-cooling heat dissipation unit (7) close to the liquid inlet system (4) and the liquid outlet system (5);
wherein the liquid inlet (102) of the first liquid-cooling dissipation unit (6) communicates with the second liquid-cooling dissipation unit (7) corresponding to the first direction through a first liquid inlet pipeline (8), and the liquid inlet (102) of the second liquid-cooling dissipation unit (7) communicates with the liquid inlet system (4) through a second liquid inlet pipeline (9);
wherein the liquid outlet of the first liquid-cooling dissipation unit (6) communicates with the second liquid-cooling dissipation unit (7) corresponding to the first direction through a first liquid outlet pipeline (10), and the liquid outlet of the second liquid-cooling dissipation unit (7) communicates with the liquid outlet system (5) through a second liquid outlet pipeline (11).

9. The liquid-cooling heat dissipation device according to claim 8, further comprising:
a second bracket (12), extending along the second direction and connected to one end of a group of the first liquid-cooling dissipation units (6) far away from the liquid inlet system (4); and
a third bracket (13), extending along the second direction and connected to one end of a group of the second liquid-cooling dissipation units (7) close to the liquid inlet system (4).

10. The liquid-cooling heat dissipation device according to claim 9, wherein both ends of the support plate (2) of the first liquid-cooling heat dissipation unit (6) in the first direction are respectively protrudingly provided with a first connecting block (61) and a second connecting block (62), and the support plate (2) of the second liquid-cooling heat dissipation unit (7) in the first direction are respectively protrudingly provided with a third connecting block (71) and a fourth connecting block (72), and the first connecting block (61), the second connecting block (62), the third connecting block (71) and the fourth connecting block (72) are all arranged at one end close to the component to be cooled;
wherein one side of the first bracket (3) in the first direction is connected to the first connecting block (61) of a group of first liquid-cooling dissipation units (6), and the other side is connected to the third connecting block (71) of a group of second liquid-cooling dissipation units (7), and the second bracket (12) is connected to the second connecting block (62) of a group of the first liquid-cooling dissipation units (6), and the third bracket (13) is connected to the fourth connecting block (72) of a group of the second liquid-cooling dissipation units (7).

11. The liquid-cooling heat dissipation device according to claim 9, wherein the first bracket (3) is provided with a first protruding part (31) protruding away from the component to be cooled, and the first liquid inlet pipeline (8) and the first liquid outlet pipeline (10) are both arranged at the first protruding part (31).

12. The liquid-cooling heat dissipation device according to claim 11, wherein the third bracket (13) is provided with a second protruding part (131) protruding away from the component to be cooled, and the second liquid inlet pipeline (9) and the second liquid outlet pipeline (11) are both arranged at the second protruding part (131).

13. The liquid-cooling heat dissipation device according to claim 9, further comprising a lifting handle (14), two ends of which are detachably connected to the second bracket (12) and the third bracket (13) respectively, and an installation groove (141) is arranged in a middle of the lifting handle (14), wherein the installation groove (141) is detachably connected to the first bracket (3), the lifting handle (14) is divided into two handle parts (142) through the installation groove (141), and an operation interval convenient for operation is formed between the handle parts (142) and the support plate (2).

14. The liquid-cooling heat dissipation device according to any one of claims 8 to 13, wherein the support plate (2) of the first liquid-cooling heat dissipation unit (6) is provided with a first avoidance groove and a second avoidance groove on the side facing the component to be cooled, and the first avoidance groove and the second avoidance groove are arranged at intervals in the second direction, and one end of the first liquid inlet pipeline (8) is arranged in the first avoidance groove, and one end of the first liquid out pipeline (10) is arranged in the second avoidance groove;
the side of the second liquid-cooling dissipation unit (7) facing the component to be cooled is provided with a third avoidance groove (24) and a fourth avoidance groove (25), and the third avoidance groove (24) and the fourth avoidance groove (25) are arranged at intervals in the second direction, and both ends of the second liquid-cooling dissipation unit (7) in the first direction are provided with the third avoidance groove (24) and the fourth avoidance groove (25);
an other end of the first liquid inlet pipeline (8) is arranged in the third avoidance groove (24) close to the first liquid-cooling dissipation unit (6), and an other end of the first liquid outlet pipeline (10) is arranged in the fourth avoidance groove (25) close to the first liquid-cooling dissipation unit (6);
one end of the second liquid inlet pipeline (9) is arranged in the third avoidance groove (24) close to the liquid inlet system (4), and one end of the second liquid outlet pipeline (11) is arranged in the fourth avoidance groove (25) close to the liquid outlet system (5).

15. The liquid-cooling heat dissipation device according to any one of claims 8 to 13, wherein the liquid inlet system (4) comprises a liquid inlet separator (41) and a liquid inlet joint (42), and the liquid inlet separator (41) communicates with one end of the second liquid inlet pipeline (9) far away from the second liquid-cooling heat dissipation unit (7) and communicates with the liquid inlet joint (42) through a third liquid inlet pipeline;
the liquid outlet system (5) comprises a liquid outlet collector (51) and a liquid outlet joint (52), wherein the liquid outlet collector (51) communicates with one end of the second liquid outlet pipeline (11) far away from the second liquid-cooling heat dissipation unit (7) and communicates with the liquid outlet joint (52) through a third liquid outlet pipeline (53).

16. The liquid-cooling heat dissipation device according to claim 15, wherein in the first direction, the liquid inlet separator (41) is arranged between the liquid outlet collector (51) and the second liquid-cooling heat dissipation unit (7);
the liquid inlet separator (41) is provided with a fifth avoidance groove (44), and the second liquid outlet pipeline (11) passes through the fifth avoidance groove (44) and communicates with the liquid outlet collector (51).

17. The liquid-cooling heat dissipation device according to claim 15, wherein in the first direction, the liquid outlet liquid collector (51) is arranged between the liquid inlet separator (41) and the second liquid-cooling heat dissipation unit (7);
the liquid outlet liquid collector (51) is provided with a fifth avoidance groove (44), and the second liquid inlet pipeline (9) passes through the fifth avoidance groove (44) and communicates with the liquid inlet liquid collector (41) .

18. The liquid-cooling heat dissipation device according to claim 15, further comprising a first fixing piece (15), a second fixing piece (16) and a third fixing piece (17);
wherein the first fixing piece (15) is fixedly connected to one end of the liquid inlet separator (41) and one corresponding end of the liquid outlet collector (51), and is adapted to connect to the component to be cooled;
the second fixing piece (16) is fixedly connected to the other end of the liquid inlet separator (41) and is adapted to connect to the component to be cooled;
the third fixing piece (17) is fixedly connected to the liquid inlet separator (41) and the liquid outlet collector (51), is located between the first fixing piece (15) and the second fixing piece (16), and is adapted to connect to the component to be cooled at one side of the liquid outlet collector (51) far away from the liquid inlet collector (41).

19. The liquid-cooling heat dissipation device according to claim 18, wherein the liquid-cooling heat dissipation device further comprises a fixed block (18), which is adapted to connect to a chassis of a server, and the liquid inlet joint (42) and the liquid outlet joint (52) are both connected to the fixed block (18).

20. A server, comprising a component to be cooled and the liquid-cooling heat dissipation device according to any one of claims 6 to 19, wherein the component to be cooled is a graphics processor.
